# EUROPÄISCHE PATENTSCHRIFT

(11) **EP 3 787 045 B1**
(45) Veröffentlichungstag und Bekanntmachung des Hinweises auf die Patenterteilung: **04.08.2021**
(21) Anmeldenummer: 20000295.4
(22) Anmeldetag: 18.08.2020
(51) Int. Cl.: H01L 31/0687, H01L 31/0224, H01L 31/18, H01L 23/544

(54) **MARKIERUNGSVERFAHREN**
MARKING METHOD
PROCÉDÉ DE MARQUAGE

(30) Priorität: 29.08.2019 DE 102019006090
(43) Veröffentlichungstag der Anmeldung: 03.03.2021
(73) Patentinhaber: AZUR SPACE Solar Power GmbH, 74072 Heilbronn (DE)
(72) Erfinder: Köstler, Wolfgang, 74074 Heilbronn (DE); Sommer, Steffen, 71732 Tamm (DE); Frey, Alexander, 74081 Heilbronn (DE)
(74) Vertreter: Koch Müller Patentanwaltsgesellschaft mbH

(56) Entgegenhaltungen:
- DE-A1-102009 009 499
- TW-A- 201 120 594
- US-A1- 2016 064 334
- US-A1- 2019 181 289
- PILAR SWART ET AL: "Assessment of the overall resource consumption of germanium wafer production for high concentration photovoltaics", RESOURCES, CONSERVATION AND RECYCLING, ELSEVIER, AMSTERDAM, NL, Bd. 55, Nr. 12, 29. Juni 2011 (2011-06-29) , Seiten 1119-1128, XP028300260, ISSN: 0921-3449, DOI: 10.1016/J.RESCONREC.2011.06.016 [gefunden am 2011-07-05]
- YANG HONGXING ET AL: "Research on laser marking technology of Ge wafers", BANDAOTI JISHU - SEMICONDUCTOR TECHNOLOGY, GAI-KAN BIANJIBU, SHIJIAZHUANG, CN, Bd. 34, Nr. 7, 30. Juni 2009 (2009-06-30), Seiten 676-678, XP009524868, ISSN: 1003-353X
- M Niemeyer ET AL: "NEXT GENERATION OF WAFER-BONDED MULTI-JUNCTION SOLAR CELLS", Proceedings of the 29th European Photovoltaic Solar Energy Conference and Exhibition, 2014, Seiten 1991-1995, XP055302046, Sylvensteinstr. 2 81369 Munich, Germany DOI: 10.4229/EUPVSEC20142014-4BO.10.2 ISBN: 978-3-936338-34-8 Gefunden im Internet: URL:https://www.eupvsec-proceedings.com/pr oceedings?paper=26967 [gefunden am 2016-09-13]

## Beschreibung

Die Erfindung betrifft ein Markierungsverfahren zum Aufbringen einer eindeutigen Kennzeichnung auf jeden einzelnen Solarzellenstapel einer Halbleiterscheibe.

Die Nachverfolgbarkeit ist bei der Herstellung von Halbleiterbauelementen ein wichtiges Werkzeug, um Prozesse zu überwachen und zu optimieren. Um Solarzellenstapel nachverfolgbar zu machen werden diese mit einer eindeutigen Kennzeichnung, z.B. einer fortlaufenden Nummer, versehen. Beispielsweise werden Solarzellenstapel nach einer Endkontrolle mittels Ink-Jet markiert.

Aus der DE 10 2009 009 499 A1 ist Markierungsverfahren für unprozessierte Halbleitersubstrate bekannt, wobei die Markierung auf der Substratrückseite angeordnet wird.

Aus PILAR SWART ET AL: "Assessment of the overall resource consumption of germanium wafer production for high concentration photovoltaics", RESOURCES, CONSERVATION AND RECYCLING, ELSEVIER, AMSTERDAM, NL, Bd. 55, Nr. 12, 29. Juni 2011, Seiten 119-1128, und aus YANG HONGXING ET AL: "Research on laser marking technology of Ge wafers", BANDAOTI JISHU - SEMICONDUCTOR TECHNOLOGY, GAI-KAN BIANJIBU, SHIJIAZHUANG, CN, Bd. 34, Nr. 7, 30. Juni 2009, Seiten 676-678, und aus M Niemeyer ET AL: "NEXT GENERATION OF WAFER-BONDED MULTI-JUNCTION SOLAR CELLS", Proceedings of the 29th European Photovoltaic Solar Energy Conference and Exhibition, 2014, Seiten 1991-1995, und der TW 201 120 594 A sind weitere Verfahren und Vorrichtungen bekannt.

Aus der US 2009/050198 A1 ist ein Markierungsverfahren für Solarzellen bekannt, wobei die Markierung in einem aktiven Bereich der Solarzelle also auf einer Solarzellenvorderseite angeordnet ist. Die Markierung wird beispielsweise mittels Laserablation auf einer Vorderseite eines Halbleitersubstrats aufgebracht, bevor die Solarzelle durch Diffusion von Dotierstoffen und aufbringen von Leiterbahnen auf der Vorderseite des Halbleitersubstrats erzeugt wird.

Aus der US 2019/181289 A1 ebenfalls das Anordnen von Markierungsstrukturen auf der Vorderseite einer Solarzelle bekannt.

Aus der US 2016/064334 A1 ist ein Markierungsverfahren für Chips vor der Vereinzelung, also auf Wafer-Level bekannt, wobei die Markierung als Teil der Rückseitenkontaktierungsstruktur ausgebildet wird.

Aus der US 2016/172306 A ist das Anordnen einer Markierung auf der Vorderseite jedes Chips vor dem Vereinzeln bekannt.

Vor diesem Hintergrund besteht die Aufgabe der Erfindung darin, eine Vorrichtung anzugeben, die den Stand der Technik weiterbildet.

Die Aufgabe wird durch ein Markierungsverfahren mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein Markierungsverfahren zum Aufbringen einer eindeutigen Kennzeichnung auf jeden einzelnen Solarzellenstapel einer Halbleiterscheibe bereitgestellt, mindestens umfassend die Schritte:
- Bereitstellen einer Halbleiterscheibe mit einer Oberseite, einer Unterseite und umfassend ein die Unterseite ausbildendes Ge-Substrat,
- Erzeugen einer Kennzeichnung mit einer eindeutigen Topografie mittels Laser-Ablation mit einem ersten Laser auf einem Oberflächenbereich der Unterseite jedes Solarzellenstapels der Halbleiterscheibe, wobei der Oberflächenbereich jeweils durch das Ge-Substrat oder durch eine das Ge-Substrat bedeckende Isolationsschicht ausgebildet ist.

Es versteht sich, dass die Kennzeichnung beispielsweise als ein beliebiges Muster, wie ein Strichcode oder ein 2D-Code oder Matrix-Code oder auch als eine Zahlen- und/oder Buchstabenfolge ausbilden lässt, welche eindeutig identifizierbar ist.

Weiterhin versteht es sich, dass die Ge-Halbleiterscheibe, die vorzugsweise einen Durchmesser von 100 mm oder 150 mm umfasst, wenigstens zwei Solarzellenstapel aufweist. Vorzugsweise sind die beiden Solarzellenstapel auf der Oberseite der Halbleiterscheibe mittels einer Separationsbereichs voneinander getrennt.

Auch sei angemerkt, dass es sich bei dem Solarzellenstapel vorzugsweise um eine Mehrfachsolarzelle handelt. Derartige Mehrfachsolarzellen weisen mehrere p-n Übergänge auf, wobei die p-n Übergänge mittels Tunneldioden seriell verschaltet sind. In einer Weiterbildung ist der Stapel der Mehrfachsolarzellen monolithisch ausgebildet.

Mittels Laser-Ablation werden Gräben/Vertiefungen unterschiedlicher Tiefe in dem Oberflächenbereich der Solarzellenstapelunterseite erzeugt, so dass sich die eindeutige Topografie ergibt, wobei die Tiefe jeweils von dem Energieeintrag abhängt.

Mittels Laser-Ablation lässt sich auf einfache, schnelle und zuverlässige Weise eine eindeutige Topographie erzeugen.

Durch das Markieren der einzelnen Solarzellen im Verbund der Halbleiterscheibe, also vor dem Vereinzeln bzw. auf Wafer-level, muss nur ein einziger Justier-Schritt für alle Solarzellenstapel der Halbleiterscheibe durchgeführt werden. Außerdem lassen sich die einzelnen Solarzellenstapel bereits von diesem frühen Zeitpunkt im Herstellungsprozess an ohne weitere Dokumentation eindeutig identifizieren.

Für die Laser-Ablation wird gemäß einer ersten Ausführungsform ein gepulster Laser mit einer Wellenlänge zwischen 1070 nm und 315 nm oder zwischen 1,5 µm und 10,6 µm verwendet und/oder eine Pulsdauer beträgt zwischen 10 fs und 100 ns. Gemäß einer weiteren Ausführungsform wird ein Laser mit einer Wellenlänge zwischen 1030 nm und 1070 nm und einer Pulsdauer von mindestens 500 fs und höchstens 30 ns verwendet. Ein Durchmesser des Fokuspunkts beträgt beispielsweise zwischen 20 µm und 40 µm, z.B. bei einer Brennweite von ca. 160 mm.

Da Laser häufig für andere Prozessschritte, z.B. Erzeugen von Durchgangsöffnungen und/oder Trenngräben, bereits vorhanden sind, ist wenig zusätzlicher Aufwand für das erfindungsgemäße Markierungsverfahren notwendig.

In einer anderen Ausführungsform wird nach dem Erzeugen der eindeutigen Kennzeichnung ein Ätzprozess mit einer ersten Ätzlösung zur Reinigung und Vertiefung der Topographie der Kennzeichnungen durchgeführt.

Durch das zusätzliche Vertiefen der Topografie mittels eines Ätzprozesses lässt sich der Energieeintrag der Laser-Ablation und / oder die Prozesszeit reduzieren, wobei eine ausreichende Tiefe und hiermit ein erhöhter Kontrast der Kennzeichnung mittels des Ätzprozesses erreicht wird.

Des Welteren lassen sich Schäden durch einen zu hohen Wärmeeintrag zuverlässiger vermeiden. Außerdem stellt ein anschließender Ätzprozess sicher, dass eventuelle Verunreinigungen zuverlässig entfernt werden.

Da die Prozesstechnik, also ein entsprechender Ätzprozess häufig bereits für das weitere Herstellungsverfahren vorhanden ist, bedeutet dieser weitere Prozessschritt kaum oder keinen Mehraufwand.

Ein weiterer Vorteil ist, dass die Rückseite nach der Ausbildung der Markierungen nur geringe lokale Vertiefungen von wenigen µm aufweist. Hierdurch wird eine Induktion von Rissen während der weiteren Prozessschritte unterdrückt.

Gemäß einer anderen Weiterbildung wird der durch das Ge-Substrat gebildete Oberflächenbereich zusammen mit der Unterseite des Ge-Substrats nach dem Aufbringen der eindeutigen Kennzeichnungen metallisiert.

Hierdurch wird die Kennzeichnung durch die Metallschicht vor Umwelteinflüssen bzw. Veränderungen geschützt, wobei sie durch die Metallschicht erkennbar bleibt. Außerdem wird sichergestellt, dass der Wärmeeintrag zur Erzeugung der Kennzeichnung die Metallisierung nicht beschädigen kann.

In einer anderen Weiterbildung werden die Solarzellenstapel der Halbleiterscheibe nach dem Aufbringen der eindeutigen Kennzeichnung vereinzelt.

In einer weiteren Ausführungsform wird die Kennzeichnung vor einem Aufwachsen von Schichten auf dem Ge-Substrat durchgeführt. So können keine Schäden durch den Wärmeeintrag und den erzeugten Ablationsstaub durch den Markierprozess auftreten.

In einer Weiterbildung wird die Kennzeichnung erst nach einem Aufwachsen von Schichten auf dem Ge-Substrat durchgeführt. Vorzugsweise wird die Kennzeichnung nach dem Aufbringen von Isolationsschichten auf die Vorderseite durchgeführt.

In einer alternativen Ausführungsform weist die Halbleiterscheibe mehrere Solarzellenstapel, vorzugsweise mehr als zwei oder mehr als drei, auf, wobei jeder Solarzellenstapel jeweils in der genannten Reihenfolge das die Unterseite ausbildende Ge-Substrat, eine Ge-Teilzelle und mindestens zwei III-V-Teilzellen aufweist. Hierbei werden mit Teilzellen Solarteilzellen verstanden, wobei jede Solarteilzelle genau einen p-n Übergang aufweist.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die laterale und die vertikale Erstreckung sind nicht maßstäblich und weisen, sofern nicht anders angegeben, auch keine ableitbaren geometrischen Relationen zueinander auf. Darin zeigen, die
- Figur 1: eine gemäß einer ersten Ausführungsform eines Markierungsverfahrens markierte Halbleiterscheibe,
- Figur 2: einen schematischen Ablauf einer erfindungsgemäßen Ausführungsform des Markierungsverfahrens.

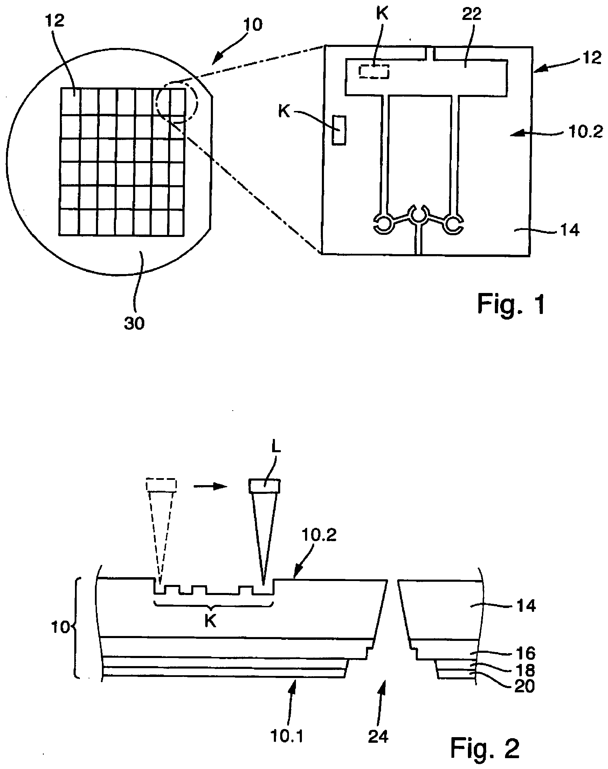

Die Abbildung der Figur 1 zeigt eine Aufsicht auf eine gemäß einer ersten Ausführungsform eines Markierungsverfahrens markiert Halbleiterscheibe 10. Die Halbleiterscheibe weist eine Oberseite 10.1 und eine Unterseite 10.2 sowie mehrere Solarzellenstapel 12 auf, wobei jeder Solarzellenstapel zumindest ein die Unterseite 10.1 ausbildende Ge-Substrat 14 umfasst.

Die Unterseite 10.1 weist im Bereich jedes Solarzellenstapels 12 auf dem Ge-Substrat jeweils eine gebietsweise ausgebildete dielektrische Isolationsschicht 22 auf. Jeder Solarzellenstapel 12 weist auf der Unterseite 10.2 einen Oberflächenbereich mit einer eindeutigen Kennzeichnung K auf, wobei die Kennzeichnung K bzw. der Oberflächenbereich auf Ge-Substrat 14 ausgebildet ist. Alternativ ist die Kennzeichnung K bzw. der Oberflächenbereich auf der dielektrischen Isolationsschicht 22 ausgebildet (gestrichelt dargestellt).

In der Abbildung der Figur 2 ist eine weitere Ausführungsform dargestellt. Im Folgenden werden nur die Unterschiede zu der Abbildung der Figur 1 erläutert.

Die ausschnittsweise als Querschnitt dargestellte Halbleiterscheibe 10 weist auf der die Unterseite 10.2 ausbildenden Ge-Substratschicht 14 eine Ge-Teilzelle 16, eine erste III-V-Teilzelle 18 und eine Oberseite 10.1 der Halbleiterscheibe 10 ausbildende zweite III-V-Teilzelle 20 in der genannten Reihenfolge sowie eine sich von der Oberseite 10.1 bis zu der Unterseite 10.2 erstreckende Durchgangsöffnung 24 auf.

Die Kennzeichnung K wird mittels Laser-Ablation mit einem ersten Laser L erzeugt. Die Kennzeichnung umfasst eine eindeutige Topografie auf dem Oberflächenbereich der Unterseite 10.2 der Halbleiterscheibe 10.

## Patentansprüche

1. Markierungsverfahren zum Aufbringen einer eindeutigen Kennzeichnung (K) auf jeden einzelnen Solarzellenstapel (12) einer mindestens zwei Solarzellenstapel (12) aufweisenden Halbleiterscheibe (10), mindestens umfassend die Schritte:
- Bereitstellen einer Halbleiterscheibe (10) mit einer Oberseite (10.1), einer Unterseite (10.2) und umfassend ein die Unterseite (10.2) ausbildendes Ge-Substrat (14),
- Erzeugen einer Kennzeichnung mit einer eindeutigen Topografie mittels Laser-Ablation mit einem ersten Laser in einem Oberflächenbereich der Unterseite (10.2) jedes Solarzellenstapels (12) der Halbleiterscheibe (10),
- wobei der Oberflächenbereich jeweils durch das Ge-Substrat (14) oder durch eine das Ge-Substrat (14) bedeckende Isolationsschicht (22) ausgebildet ist.

2. Verfahren nach Anspruch 1, **dadurch gekennzeichnet, dass** nach dem Erzeugen der eindeutigen Kennzeichnung (K) ein Ätzprozess mit einer ersten Ätzlösung zur Reinigung und Vertiefung der Topographie der Kennzeichnungen (K) durchgeführt wird.

3. Verfahren nach Anspruch 1 oder 2, **dadurch gekennzeichnet, dass** der durch das Ge-Substrat (14) gebildete Oberflächenbereich zusammen mit der Unterseite (10.1) des Ge-Substrats (14) nach dem Aufbringen der eindeutigen Kennzeichnungen (K) metallisiert wird.

4. Verfahren nach einem der vorstehenden Ansprüche, **dadurch gekennzeichnet, dass** die Solarzellenstapel (12) der Halbleiterscheibe (10) nach dem Aufbringen der eindeutigen Kennzeichnung (K) vereinzelt werden.

5. Verfahren nach einem der vorstehenden Ansprüche, **dadurch gekennzeichnet, dass** die Kennzeichnung vor einem Aufwachsen von Schichten auf dem Ge-Substrat (14) durchgeführt wird.

6. Verfahren nach einem der Ansprüche 1 bis 4, **dadurch gekennzeichnet, dass** die Kennzeichnung nach einem Aufwachsen von Schichten auf dem Ge-Substrat (14) durchgeführt wird.

7. Verfahren nach einem der vorstehenden Ansprüche, **dadurch gekennzeichnet, dass** die Halbleiterscheibe (10) mehrere Solarzellenstapel (12) aufweist, wobei jeder Solarzellenstapel jeweils in der genannten Reihenfolge das die Unterseite (10.2) ausbildende Ge-Substrat (14), eine Ge-Teilzelle (16) und mindestens zwei III-V-Teilzellen (18, 20) aufweist.

## Claims

1. Marking method for application of a unique marking (K) to each individual solar cell stack (12) of a semiconductor wafer (10) comprising at least two solar cell stacks (12), comprising at least the steps:
- providing a semiconductor wafer (10) with an upper side (10.1), a lower side (10.2) and comprising a Ge substrate (14) forming the lower side (10.2),
- producing a marking with a unique topography by means of laser ablation by a first laser in a surface region of the lower side (10.2) of each solar cell stack (12) of the semiconductor wafer (10),
- wherein the surface region is respectively formed by the Ge substrate (14) or by an insulation layer (22) covering the Ge substrate (14).

2. Method according to claim 1, **characterised in that** after production of the unique marking (K) an etching process with a first etching solution for cleaning and deepening the topography of the markings (K) is performed.

3. Method according to claim 1 or 2, **characterised in that** the surface region formed by the Ge substrate (14) is metallised together with the lower side (10.1) of the Ge substrate (14) after application of the unique markings (K).

4. Method according to any one of the preceding claims, **characterised in that** the solar cell stacks (12) of the semiconductor wafer (10) are separated after application of the unique marking (K).

5. Method according to any one of the preceding claims, **characterised in that** the marking is undertaken before epitaxis of layers on the Ge substrate (14).

6. Method according to any one of claims 1 to 4, **characterised in that** the marking is undertaken after epitaxis of layers on the Ge substrate (14).

7. Method according to any one of the preceding claims, **characterised in that** the semiconductor wafer (10) comprises a plurality of solar cell stacks (12), wherein each solar cell stack respectively has in the stated sequence the Ge substrate (14) forming the lower side (10.2), a Ge part cell (16) and at least two III-V part cells (18. 20).

## Revendications

1. Procédé de marquage pour apposer un identifiant univoque (K) sur chaque pile de cellules solaires (12) d'une plaquette semi-conductrice (10) présentant au moins deux piles de cellules solaires (12), comprenant au moins les étapes suivantes :
- préparation d'une plaquette semi-conductrice (10) avec une face supérieure (10.1) et une face inférieure (10.2), et comprenant un substrat en Ge (14) constituant la face inférieure (10.2),
- réalisation d'un identifiant doté d'une topographie univoque par ablation laser avec un premier laser dans une zone superficielle de la face inférieure (10.2) de chaque pile de cellules solaires (12) de la plaquette semi-conductrice (10),
- la zone superficielle étant constituée par le substrat en Ge (14) ou par une couche isolante (22) recouvrant le substrat en Ge (14).

2. Procédé selon la revendication 1, **caractérisé en ce qu'**après la réalisation de l'identifiant univoque (K), une procédure de gravure est exécutée avec une première solution de gravure pour nettoyer et approfondir la topographie des identifiants (K).

3. Procédé selon la revendication 1 ou 2, **caractérisé en ce que** la zone superficielle formée par le substrat en Ge (14) est métallisée avec la face inférieure (10.1) du substrat en Ge (14) après l'apposition des identifiants univoques (K).

4. Procédé selon l'une des revendications précédentes, **caractérisé en ce que** les piles de cellules solaires (12) de la plaquette semi-conductrice (10) sont séparées après l'apposition de l'identifiant univoque (K).

5. Procédé selon l'une des revendications précédentes, **caractérisé en ce que** l'identification est effectuée avant un accroissement de couches sur le substrat en Ge (14).

6. Procédé selon une des revendications 1 à 4, **caractérisé en ce que** l'identification est effectuée après un accroissement de couches sur le substrat en Ge (14).

7. Procédé selon l'une des revendications précédentes, **caractérisé en ce que** la plaquette semi-conductrice (10) présente plusieurs piles de cellules solaires (12), chaque pile de cellules solaires présentant dans cet ordre de succession le substrat en Ge (14) constituant la face inférieure (10.2), une sous-cellule en Ge (16) et au moins deux sous-cellules III-V (18, 20).
